# EUROPEAN PATENT APPLICATION

(11) **EP 4 661 634 A1**
(43) Date of publication of application: **10.12.2025**
(21) Application number: 25175190.5
(22) Date of filing: 08.05.2025
(51) Int. Cl.: H10H 20/84, H10H 20/851, H10H 20/854

(54) **LIGHT EMITTING DEVICE PACKAGE, PLANAR LIGHTING DEVICE USING SAME, AND DISPLAY DEVICE USING SAME**

(30) Priority: 04.06.2024 KR 20240072840
(71) Applicant: LG Electronics Inc., Yeongdeungpo-gu Seoul 07336 (KR)
(72) Inventor: KIM, Jaehyeok, Seoul (KR); LEE, Jeoungoun, Seoul (KR); JEONG, Sehoon, Seoul (KR)
(74) Representative: Vossius & Partner Patentanwälte Rechtsanwälte mbB

(57) **Abstract**

The present disclosure is applicable to technical fields related to a display device, for example, relates to a display device using a composite optical film and a light emitting diode (LED). A light emitting device package includes a light emitting device configured to emit light having a first color, a wavelength conversion part having a first main emission wavelength and a second main emission wavelength and disposed around the light emitting device to convert a wavelength of at least a portion of the light having the first color emitted from the light emitting device to light having a second color, a light absorption part having an absorption center wavelength between the first color and the second color of the wavelength conversion part, and a protective agent configured to protect the light absorption part from at least a portion of ambient light.

## Description

### BACKGROUND

The present disclosure is applicable to technical fields related to a display device, for example, relates to a light emitting device package, a planar lighting device using the same, and a display device using the same.

Recently, display devices having excellent characteristics such as thinness, flexibility, etc., are being developed in the fields of display technologies. The major displays currently commercialized are represented by liquid crystal displays (LCDs) and organic light emitting diodes (OLEDs).

In the displays, the liquid crystal display devices (LCDs) are used in a variety of devices including televisions, laptop computers, desktop computer monitors, and mobile phones.

Since the LCDs do not emit light by themselves, a light emitting device that is capable of illuminating a liquid crystal panel is required to display image information.

Since the light emitting device of the LCD is connected to a rear surface of the liquid crystal panel, the light emitting device may be called a planar lighting device or a backlight unit. The backlight unit may be called a device that forms a uniform surface light source to provide a light source to the liquid crystal panel.

The backlight unit as described above may be considered an example of the planar lighting device because the backlight unit provides a planar light source toward the liquid crystal panel. The planar lighting device is recognized as a light source that is capable of evenly irradiating light through a flat surface and have a relatively thin thickness.

The light emitting device such as the light emitting diode is used as the light source for the planar lighting device. To implement a white light source in the light emitting device, a blue light emitting device and a phosphor may be used in combination. For example, the blue light emitting device and a yellow phosphor may be combined to implement the white light source.

In addition, a blue light emitting device, a green phosphor, and a red phosphor may be used together for color reproduction. As described above, various methods are being attempted to reproduce high colors.

There is a demand for the implementation of the white light source capable of the high color reproduction without performance degradation over time or the display device using the same.

### SUMMARY

Embodiments provide a light emitting device package capable of improving color purity of white light emitted from the light emitting device package, a planar lighting device using the same, and a display device using the same.

Embodiments also provide a light emitting device package capable of improving color reproducibility of a planar lighting device, a planar lighting device using the same, and a display device using the same.

Embodiments also provide a light emitting device capable of preventing a light absorption part from being damaged or at least partially preventing the light absorption part from being damaged, a planar lighting device using the same, and a display device using the same.

In one embodiment, a light emitting device package includes: a light emitting device configured to emit light having a first color; a wavelength conversion part having a first main emission wavelength and a second main emission wavelength and disposed around the light emitting device to convert a wavelength of at least a portion of the light having the first color emitted from the light emitting device to light having a second color; a light absorption part having an absorption center wavelength between the first color and the second color of the wavelength conversion part; and a protective agent configured to protect the light absorption part from at least a portion of ambient light.

In another embodiment, a planar lighting device includes: a light emitting device package including a light emitting device configured to emit light having a first color, a wavelength conversion part disposed around the light emitting device to convert a wavelength of at least a portion of the light having the first color having a first main emission wavelength and a second main emission wavelength and emitted from the light emitting device, thereby emitting light having a second color, a light absorption part having an absorption center wavelength between the first color and the second color of the wavelength conversion part, and a protective agent configured to protect the light absorption part from at least a portion of ambient light, wherein the light emitting device, the wavelength conversion part, the light absorption part, and the protective agent are arranged on a substrate; a light diffusion layer disposed on the light emitting device package; and an optical sheet disposed on the light diffusion layer.

In further another embodiment, a display device includes: a planar lighting device; and a liquid crystal display panel disposed on the planar lighting device, wherein the planar lighting device includes: a light emitting device package comprising a light emitting device configured to emit light having a first color, a wavelength conversion part having a first main emission wavelength and a second main emission wavelength and disposed around the light emitting device to convert a wavelength of at least a portion of the light having the first color and emitted from the light emitting device to light having a second color, a light absorption part having an absorption center wavelength between the wavelength corresponding to the first color and the wavelength corresponding to the second color of the wavelength conversion part, and a UV protection agent configured to protect the light absorption part from ultraviolet ray, wherein the light emitting device, the wavelength conversion part, the light absorption part, and the UV protective agent are arranged on a substrate; a light diffusion layer disposed on the light emitting device package; and an optical sheet disposed on the light diffusion layer.

The details of one or more embodiments are set forth in the accompanying drawings and the description below. Other features will be apparent from the description and drawings, and from the claims.

### BRIEF DESCRIPTION OF THE DRAWINGS

FIG. 1 is a schematic cross-sectional view illustrating a light emitting device package according to an embodiment of the present disclosure.
FIG. 2 is a view illustrating a light absorption part and a protective agent according to an embodiment of the present disclosure.
FIG. 3 is a graph illustrating an emission spectrum of the light emitting device package when a light absorption layer is not applied.
FIG. 4 is a graph illustrating an emission spectrum of the light emitting device package when the light absorption layer is applied.
FIG. 5 is a graph illustrating an absorption spectrum by the light absorption layer.

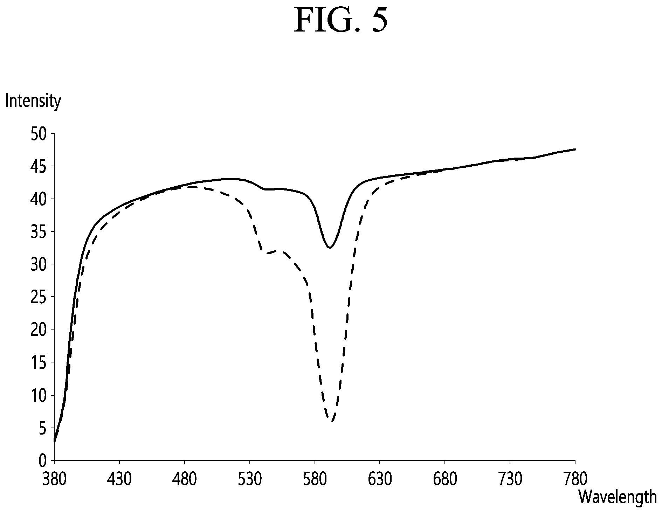

FIGS. 5 to 9 are schematic cross-sectional views illustrating modified examples of the light emitting device package according to an embodiment of the present disclosure.

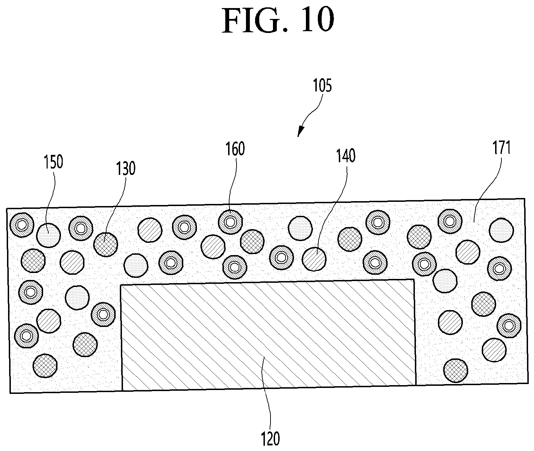

FIG. 10 is a schematic cross-sectional view illustrating a light emitting device package according to another embodiment of the present disclosure.

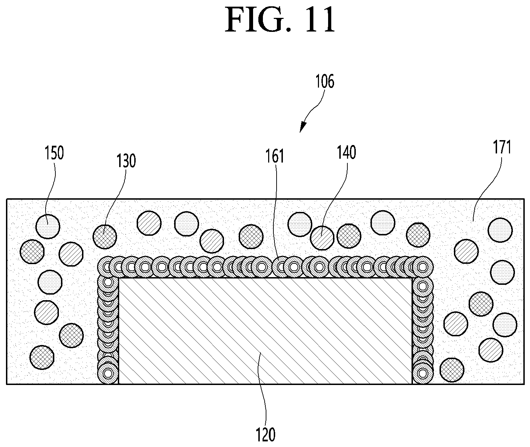

FIGS. 11 to 13 are schematic cross-sectional views illustrating modified examples of the light emitting device package according to another embodiment of the present disclosure.

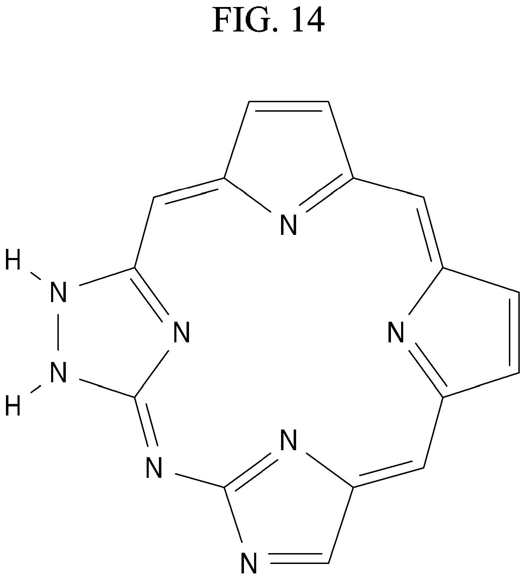

FIG. 14 is a view illustrating a molecular structure as an example of the light absorption part according to embodiments of the present disclosure.

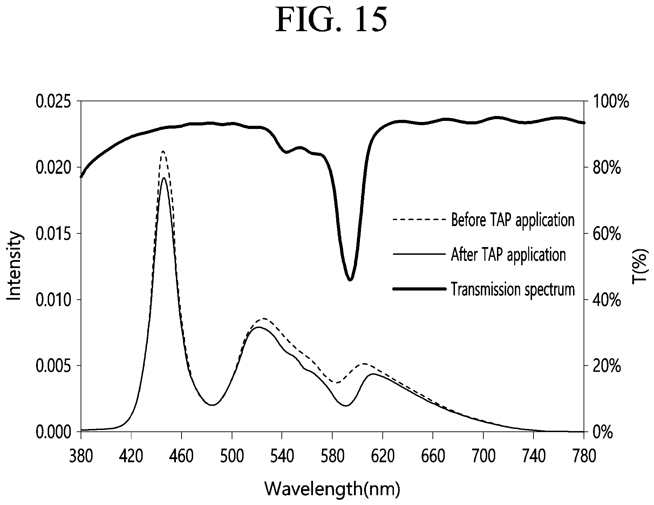

FIG. 15 is a graph illustrating an effect of the light absorption part.

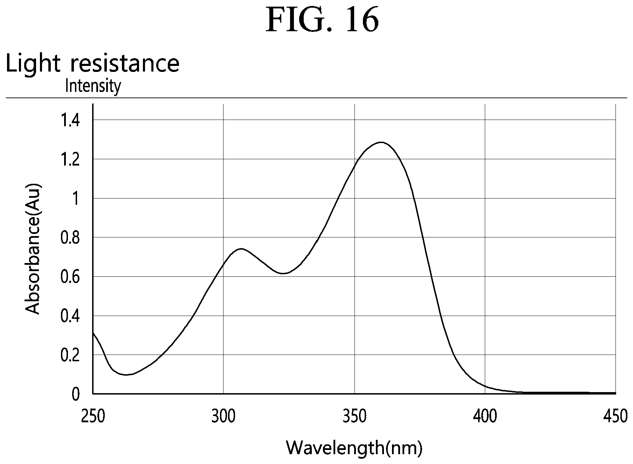

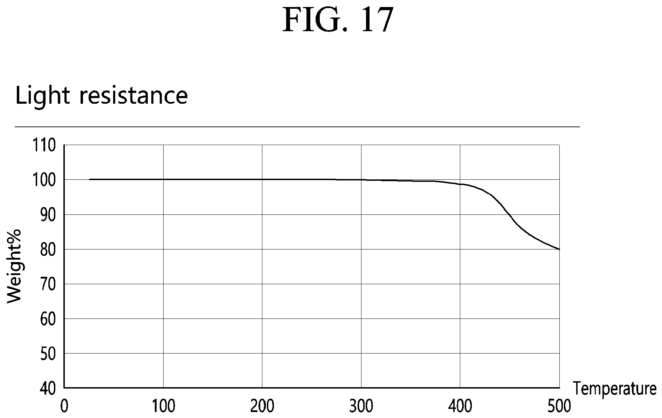

FIGS. 16 and 17 are graphs illustrating characteristics of the protective agent.

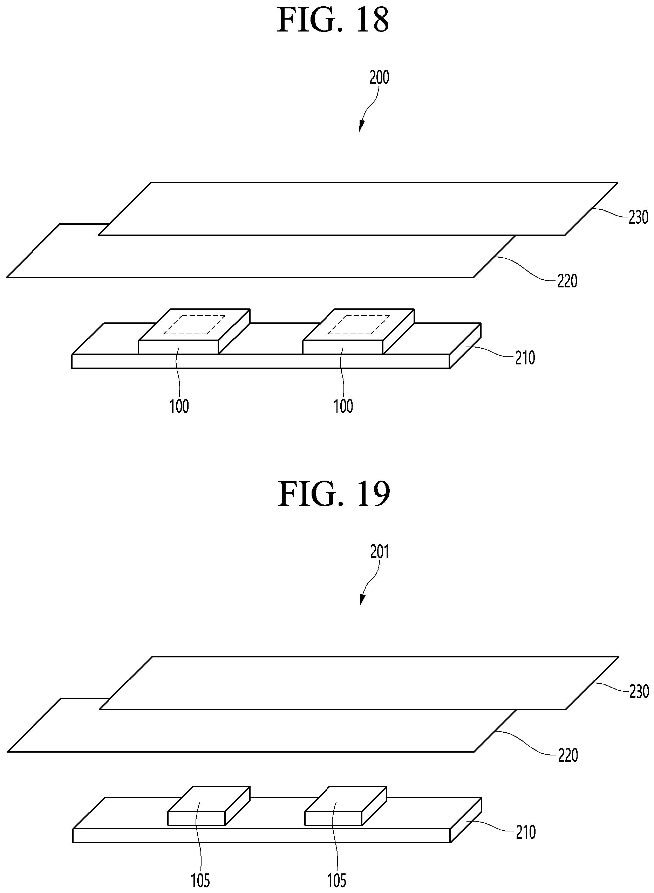

FIG. 18 is a schematic view illustrating a planar lighting device using the light emitting device package according to an embodiment of the present disclosure.
FIG. 19 is a schematic view illustrating a planar lighting device using the light emitting device package according to another embodiment of the present disclosure.

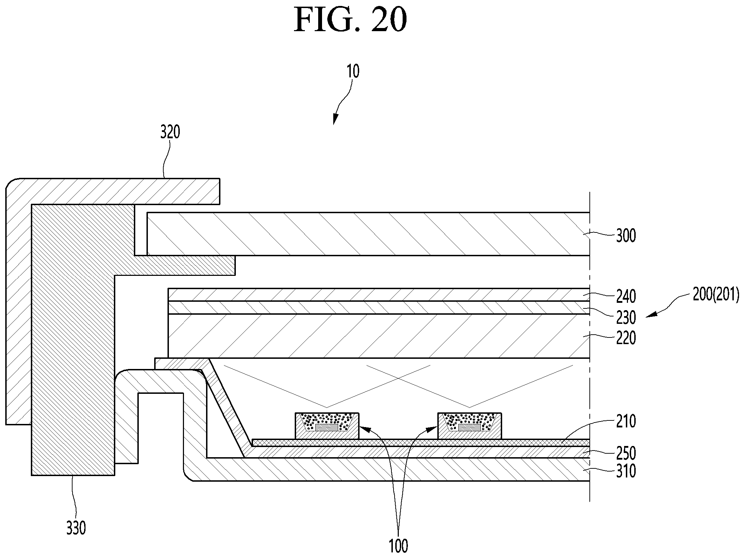

FIG. 20 is a schematic view illustrating a display device according to an embodiment of the present disclosure.

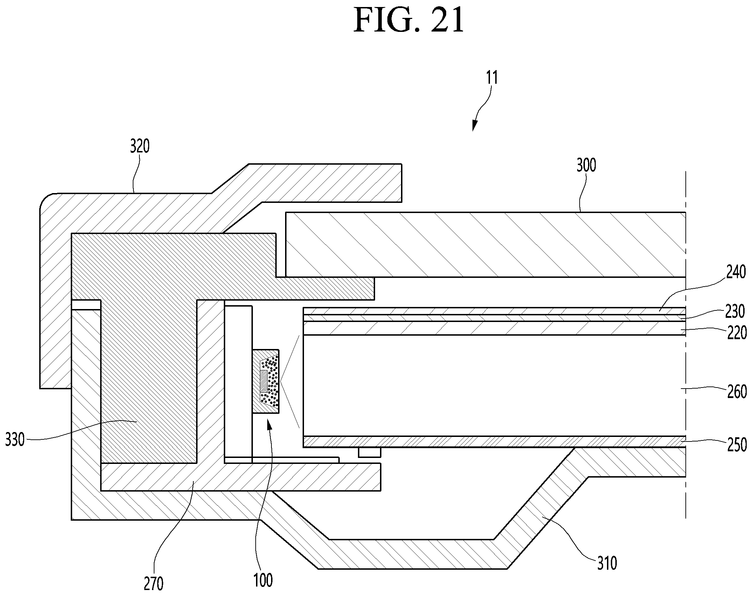

FIG. 21 is a schematic view illustrating a display device according to another embodiment of the present disclosure.

### DETAILED DESCRIPTION OF THE EMBODIMENTS

Hereinafter, embodiments disclosed in this specification is described with reference to the accompanying drawings, and the same or corresponding components are given with the same drawing number regardless of reference number, and their duplicated description will be omitted. The suffixes "module" and "part" for components used in the description below are assigned or mixed in consideration of easiness in writing the specification and do not have distinctive meanings or roles by themselves. In addition, in describing embodiments disclosed in this specification, if it is determined that detailed descriptions of related known technologies obscure the gist of the embodiments disclosed in this specification, the detailed descriptions will be omitted. In addition, it should be noted that the attached drawings are only intended to facilitate easy understanding of the embodiments disclosed in this specification, and should not be construed as limiting the technical ideas disclosed in this specification by the attached drawings.

Furthermore, although each drawing is described for convenience of explanation, it is also within the scope of the present invention for those skilled in the art to implement another embodiment by combining at least two or more drawings.

In addition, in the following description, it will be understood that when an element such as a layer, a region, or substrate is referred to as being 'on' another layer, region, or substrate, it can be directly on the other layer, region, or substrate, or intervening layers, regions, or substrates may also be present.

A display device described in this specification is a concept that includes all display devices that display information as a unit pixel or a set of unit pixels. Therefore, it may be applied not only to finished products but also to parts. For example, a panel, which is a component of a digital TV, is also considered the display device under this specification. The finished products may include mobile phones, smart phones, laptop computers, digital broadcasting terminals, personal digital assistants (PDAs), portable multimedia players (PMPs), navigation systems, slate PCs, tablet PCs, ultra books, digital TVs, and desktop computers.

However, those skilled in the art will readily recognize that the configuration according to the embodiments described herein may be applied to devices capable of displaying, even if they are new product types developed in the future.

In addition, the semiconductor light emitting device mentioned in the specification is a concept that includes LEDs, mini LEDs, micro LEDs, etc., and may be used interchangeably.

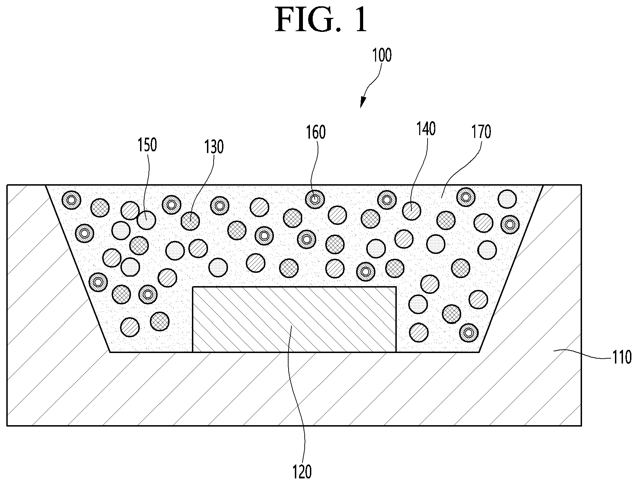

FIG. 1 is a schematic cross-sectional view illustrating a light emitting device package according to an embodiment of the present disclosure.

Referring to FIG. 1, a light emitting device package 100 according to an embodiment may include a light emitting device 120 that emits light having a first color. For example, the light emitting device 120 may be a blue light emitting device 120 that emits blue light. For example, the light having the first color may be blue light.

Wavelength conversion parts 130 and 140 may be provided around the light emitting device 120. The wavelength conversion parts 130 and 140 may convert a wavelength of at least a portion of the first color light having a first main emission wavelength and a second main emission wavelength and emitted from the light emitting device 120 to emit second color light.

For example, the wavelength conversion parts 130 and 140 may include a first phosphor 130 that emits the first color light and a second phosphor 140 that emits the second color light.

For example, the first color light may be green light, and the second color light may be red light. The first phosphor 130 may be a green phosphor that absorbs the blue light emitted from the blue light emitting device 120 to emit the green light. In addition, the second phosphor 140 may be a red phosphor that absorbs the blue light emitted from the blue light emitting device 120 to emit the red light.

The light emitting device package 100 may include a light absorption part 150 having an absorption center wavelength between the first color and the second color of the wavelength conversion part 130 and 140. Here, for example, the absorption center wavelength of the light absorption part 150 may be about 585 nm to about 605 nm. The light absorption part 150 may absorb light between the first color and the second color to improve color purity of the light emitted from the light emitting device package 100.

The light emitting device package 100 may include a protective agent 160 that protects the light absorption part 150 from at least a portion of ambient light.

For example, the protective agents 160 may include a UV protection agent. For example, the UV protection agent may block at least a portion of light having a wavelength band of about 300 nm to about 400 nm. For example, the UV protection agent may block at least a portion of light having a wavelength band of about 400 nm to about 430 nm.

According to an embodiment of the present disclosure, the light emitting device package 100 may include the light emitting device 120 that emits the first color light, the wavelength conversion parts 130 and 140 disposed around the light emitting device 120 to convert a wavelength of at least a portion of the first color light having the first main emission wavelength and the second main emission wavelength and emitted from the light emitting device 120, thereby emitting the second color light, the light absorption part 150 having an absorption center wavelength between the first color and the second color of the wavelength conversion parts 130 and 140, and the protective agent 160 that protects the light absorption part 150 from at least a portion of the ambient light.

As an exemplary embodiment, at least one of the light absorption part 150 or the protective agent 160 may be distributed in a molding layer 170 disposed on the light emitting device 120.

For example, a density of the light absorption part 150 within the molding layer 170 may be greater than that of the protective agent 160.

For example, the light absorption part 150 may include organic powder. As an exemplary embodiment, the light absorption part 150 may include a Tetra Aza Porphyrin (TAP) material.

In this case, the protective agent 160 may protect carbon linkages of the organic powder from ultraviolet rays.

As an exemplary embodiment, the wavelength conversion part 130 and 140 may include powder of a first phosphor 130 that emits the first color light and powder of a second phosphor 140 that emits the second color light. The first phosphor 130 and second phosphor 140 may be dispersed and disposed in the molding layer 170.

The molding layer 170 may be made of, for example, a transparent resin material. For example, the molding layer 170 may include a resin material such as silicone or epoxy. For example, the first phosphor 130, the second phosphor 140, the light absorption part 150, and the protective agent 160 may be dispersed and disposed within the molding layer 170.

As described above, the density of the light absorption part 150 within the molding layer 170 may be greater than the density of the protective agent 160. The light absorption part 150 and the protective agent 160 may be dispersed and disposed together within the molding layer 170. For example, an average distance between the light absorption part 150 and the protective agent 160 within the molding layer 170 may be less than an average distance between the light absorption part 150 and each of the wavelength conversion parts 130 and 140. Thus, the light absorption part 150 may be effectively protected from the ultraviolet rays.

The light emitting device 120 may be mounted inside a package body 110. For example, the package body 110 may include a reflective cup shape, and the light emitting device 120 may be mounted within the reflective cup shape. The light emitting device 120 may be flip-chip bonded within the reflective cup. The package body 110 may include an external electrode pad electrically connected to the light emitting device 120, but a detailed description thereof is omitted.

The molding layer 170 described above may be disposed within the reflective cup shape of the package body 110. For example, the molding layer 170 in which the first phosphor 130, the second phosphor 140, the light absorption part 150, and the protective agent 160 are dispersed may be disposed to be coated within the reflective cup shape of the package body 110 on which the light emitting device 120 is installed.

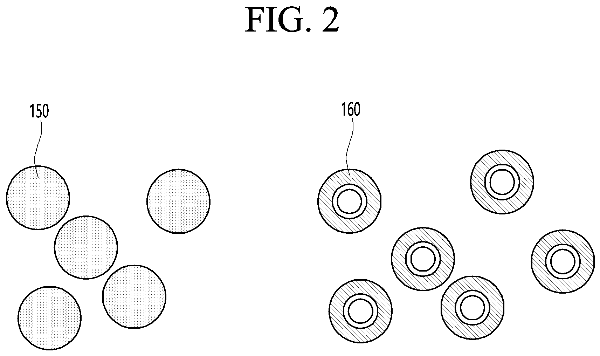

FIG. 2 is a view illustrating the light absorption part and the protective agent according to an embodiment of the present disclosure.

As described above, as an exemplary embodiment, the light absorption part 150 may be provided as the powder and then dispersed together with the protective agent 160 provided as the powder and provided within the molding layer 170.

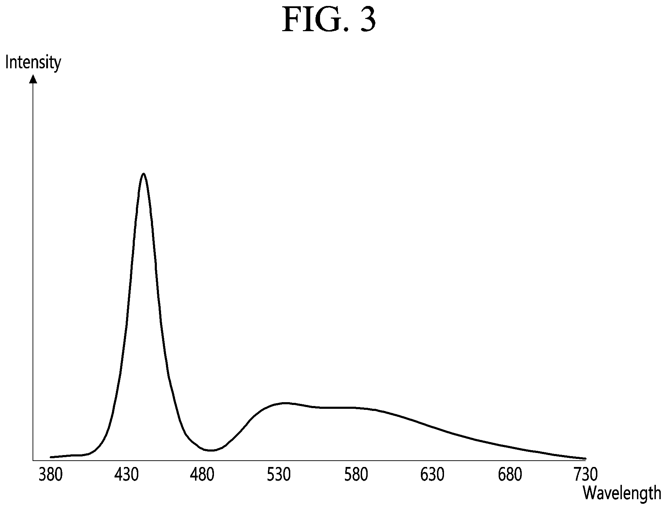

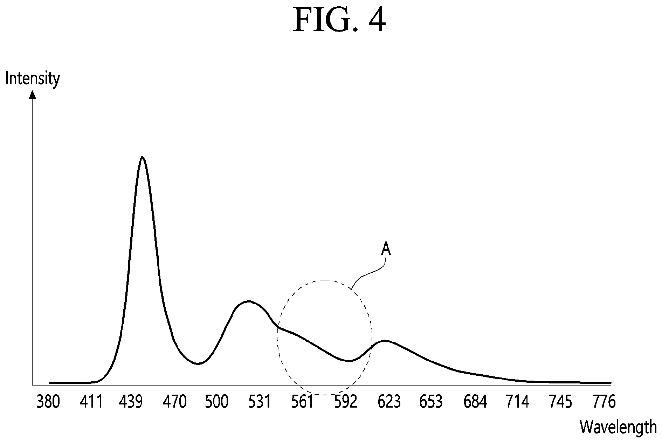

FIG. 3 is a graph illustrating an emission spectrum of the light emitting device package when the light absorption layer is not applied. FIG. 4 is a graph illustrating an emission spectrum of the light emitting device package when the light absorption layer is applied. FIG. 5 is a graph illustrating an absorption spectrum by the light absorption layer.

Hereinafter, an example will be described in which the light emitting device 120 emits the blue light, the first phosphor 130 absorbs the blue light emitted from the blue light emitting device 120 to emit the green light, and the second phosphor 140 absorbs the blue light emitted from the blue light emitting device 120 to emit the red light.

FIG. 3 illustrates an emission spectrum of the light emitting device package 100 when the light absorption part 150 is not applied.

In the emission spectrum of FIG. 3, it is seen that peaks exist in blue, green, and red wavelength bands from the left. Here, it is seen that the peaks in the green and red wavelength bands are weak and thus are practically indistinguishable from each other.

Here, a blue peak may be due to the light emitted from the light emitting device 120, the green peak may be due to the light emitted from the first phosphor 130, and the red peak may be due to the light emitted from the second phosphor 140.

FIG. 4 illustrates an emission spectrum when the light absorption part 150 is applied.

Referring to FIG. 5, the absorption spectrum of the light absorption part 150 may have, for example, an absorption center wavelength between a green wavelength and a red wavelength. That is, the peak of the absorption spectrum may be disposed between the green and red wavelengths.

For example, the peak wavelength of the absorption spectrum may be about 595 nm. The peak wavelengths may have a deviation of about 10 nm. That is, the absorption center wavelength of the light absorption part 150 may be about 585 nm to about 605 nm.

In addition, the peak of the absorption spectrum may have a full width at half maximum (FWHM) of about 30 nm. The full width at half maximum of the peak of this absorption spectrum may be controlled within a small range depending on the light absorption part 150. For example, the peak of the absorption spectrum of the light absorption part 150 may have a full width at half maximum of about 25 nm to about 35 nm.

In other words, FIG. 4 illustrates a spectrum in which the emission spectrum of FIG. 3 and the absorption spectrum (portion A) of the light absorption part 150 are mixed. It is seen that a full width at half maximum of each of the green peak and the red peak is narrowed due to light absorption at the portion A of the light absorption part 150.

As described above, the peak of the spectrum of the first phosphor 130 and the peak of the spectrum of the second phosphor 140 may be narrowed due to an absorption spectrum peak by the light absorption part 150. Thus, the color purity of each of the light emitted from the first phosphor 130 and the light emitted from the second phosphor 140 may be improved. Thus, the color purity of the white light emitted from the light emitting device package 100 may be improved. When the light emitting device package 100 is used in planar lighting devices 200 and 201 (see FIGS. 18 and 19), color reproducibility of the planar lighting devices 200 and 201 may be further improved.

Referring to FIG. 5, the absorption spectrum of the light absorption part 150 may be changed from a dotted line to a solid line. For example, the absorption spectrum of the light absorption part 150 may be deteriorated to decrease in absorbance. For example, the light absorption part 150 may be deteriorated by the ultraviolet rays to decrease in light absorbance. As a result, performance of improving the color purity as described above may be gradually deteriorated.

One of the main causes of the deterioration of the light absorbing parts 150 may be damage by the ultraviolet rays. For example, the light absorption part 150 may be made of an organic material, and the carbon linkages of the organic material may be damaged by the ultraviolet rays. The ultraviolet rays may be generated from the light emitting device 120 or may be introduced from the outside.

However, according to embodiments of the present disclosure, the light absorption part 150 may be prevented from being damaged by the ultraviolet rays or at least partially prevented from being damaged by the ultraviolet rays due to the role of the protective agent 160.

Thus, the light absorption part 150 may maintain the light absorption performance for a long period of time, and thus, the performance of improving the color purity described above may be maintained. This will be described in more detail later.

FIGS. 5 to 9 are schematic cross-sectional views illustrating modified examples of the light emitting device package according to an embodiment of the present disclosure.

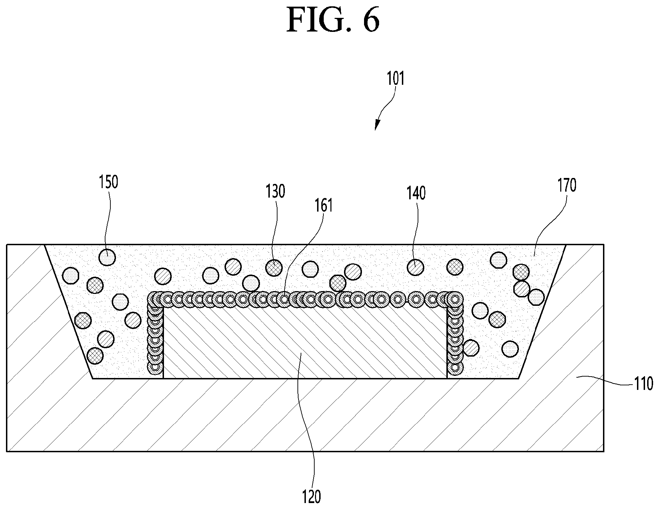

Hereinafter, modified examples of the light emitting device package according to an embodiment of the present disclosure will be exemplarily described with reference to FIGS. 6 to 9. The above descriptions of the light emitting device package 100 according to an embodiment may be applied equally to those that are not described herein.

Referring to FIG. 6, in the light emitting device package 101 according to this embodiment, the light emitting device 120 may be mounted within the package body 110. For example, the package body 110 may include a reflective cup shape, and the light emitting device 120 may be mounted within the reflective cup shape. The light emitting device 120 may be flip-chip bonded within the reflective cup.

An outer surface of the light emitting device 120 may be provided with a protective agent 161 applied thereon. For example, a powder-shaped protective agent 161 may be disposed on the outer surface of the light emitting device 120 to have a certain thickness. As another example, a resin layer in which the powder-shaped protective agent 161 is dispersed may be applied on the outer surface of the light emitting device 120.

A molding layer 170 may be disposed within the reflective cup shape of the package body 110. For example, the molding layer 170 in which the first phosphor 130, the second phosphor 140, and the light absorption part 150 are dispersed may be disposed to be coated within the reflective cup shape of the package body 110 on which the light emitting device 120 is installed.

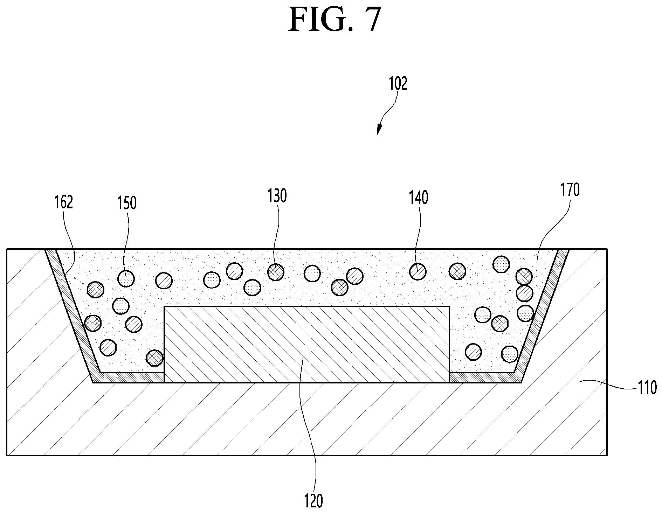

Referring to FIG. 7, in the light emitting device package 102 according to this embodiment, the light emitting device 120 may be mounted within the package body 110. For example, the package body 110 may include a reflective cup shape, and the light emitting device 120 may be mounted within the reflective cup shape. The light emitting device 120 may be flip-chip bonded within the reflective cup.

For example, a protective agent 162 may be provided in the form of a layer on a reflective surface having the reflective cup shape provided within the package body 110. For example, the protective layer 162 containing an UV protection agent may be disposed on the reflective surface having the reflective cup shape provided within the package body 110.

For example, a powder-shaped protective agent 162 may be disposed at a certain thickness on the reflective surface having the reflective cup shape provided within the package body 110. As another example, a resin layer in which the powder-shaped protective agent 162 is dispersed may be applied on the reflective surface.

A molding layer 170 may be disposed within the reflective cup shape of the package body 110. For example, the molding layer 170 in which the first phosphor 130, the second phosphor 140, and the light absorption part 150 are dispersed may be disposed to be coated within the reflective cup shape of the package body 110 on which the light emitting device 120 is installed.

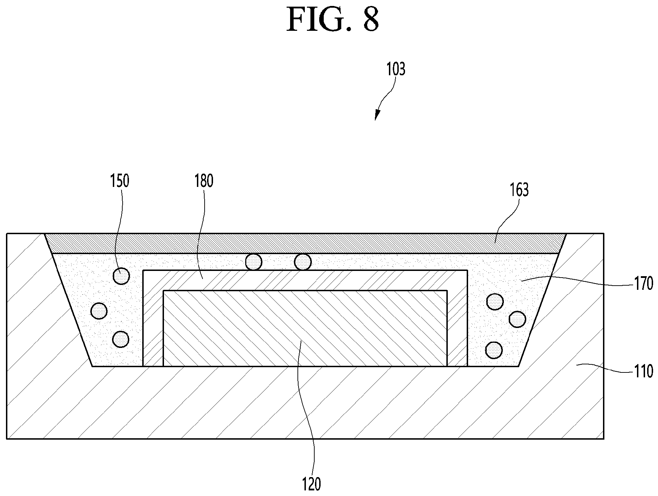

Referring to FIG. 8, in the light emitting device package 103 according to this embodiment, the light emitting device 120 may be mounted within the package body 110. For example, the package body 110 may include a reflective cup shape, and the light emitting device 120 may be mounted within the reflective cup shape. The light emitting device 120 may be flip-chip bonded within the reflective cup.

A wavelength conversion part 180 including a third phosphor that emits light having a color that is a mixture of the first color and the second color may be disposed on an outer surface of the light emitting device 120. For example, the wavelength conversion part 180 may include a resin layer in which a yellow phosphor is dispersed.

A molding layer 170 may be disposed within the reflective cup shape of the package body 110. For example, the molding layer 170 in which the light absorption part 150 is dispersed may be disposed to be coated within the reflective cup shape of the package body 110 on which the light emitting device 120 is installed.

A protective agent 163 may be provided to be coated on the molding layer 170. For example, a powder-shaped protective agent 163 may be disposed on the molding layer 170 to have a certain thickness. As another example, a resin layer in which the powder-shaped protective agent 163 is dispersed may be coated on the molding layer 170.

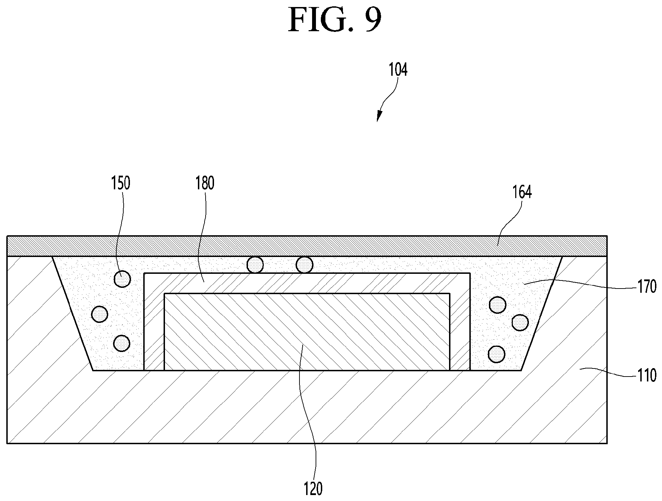

Referring to FIG. 9, in the light emitting device package 104 according to this embodiment, the light emitting device 120 may be mounted within the package body 110.

A wavelength conversion part 180 including a third phosphor that emits light having a color that is a mixture of the first color and the second color may be disposed on an outer surface of the light emitting device 120. For example, the wavelength conversion part 180 may include a resin layer in which a yellow phosphor is dispersed.

A molding layer 170 may be disposed within the reflective cup shape of the package body 110. For example, the molding layer 170 in which the light absorption part 150 is dispersed may be disposed to be coated within the reflective cup shape of the package body 110 on which the light emitting device 120 is installed.

A protective agent 164 may be provided to be coated on the molding layer 170. The protective agent 164 may be provided in the form of a layer to cover an entire top surface of the package body 110.

FIG. 10 is a schematic cross-sectional view illustrating a light emitting device package according to another embodiment of the present disclosure.

FIG. 10 illustrates an example of a light emitting device package 105 provided in the form of a chip scale package (CSP) in which a molding layer 171, in which at least wavelength conversion parts 130 and 140 and a light absorption part 150 are disposed, is coated in the form of a package on the light emitting device 120.

Referring to FIG. 10, the molding layer 171 having a certain thickness may be disposed on an outer surface of the light emitting device 120 excluding a bottom surface of the light emitting device 120.

A first phosphor 130, a second phosphor 140, the light absorption part 150, and a protective agent 160 may be dispersed and disposed in the molding layer 171.

As an exemplary embodiment, the wavelength conversion part 130 and 140 may include powder of a first phosphor 130 that emits the first color light and powder of a second phosphor 140 that emits the second color light. The first phosphor 130 and second phosphor 140 may be dispersed and disposed in the molding layer 171.

The molding layer 171 may be made of, for example, a transparent resin material. For example, the molding layer 171 may include a resin material such as silicone or epoxy. For example, the first phosphor 130, the second phosphor 140, the light absorption part 150, and the protective agent 160 may be dispersed and disposed within the molding layer 171.

As described above, the density of the light absorption part 150 within the molding layer 171 may be greater than the density of the protective agent 160. The light absorption part 150 and the protective agent 160 may be dispersed and disposed together within the molding layer 171. For example, an average distance between the light absorption part 150 and the protective agent 160 within the molding layer 171 may be less than an average distance between the light absorption part 150 and each of the wavelength conversion parts 130 and 140. Thus, the light absorption part 150 may be effectively protected from the ultraviolet rays.

Although not shown, two electrodes of the light emitting device 120 may be disposed on the bottom surface of the light emitting device 120. As another example, the two electrodes of the light emitting device 120 may be disposed at an upper side by passing through the molding layer 171. A detailed description of this structure is omitted.

The above description of the first embodiment described may be applied equally to those that are not described herein. Therefore, duplicated descriptions are omitted.

FIGS. 11 to 13 are schematic cross-sectional views illustrating modified examples of the light emitting device package according to another embodiment of the present disclosure.

Hereinafter, modified examples of the light emitting device package according to another embodiment of the present disclosure will be exemplarily described with reference to FIGS. 11 to 13. The above descriptions of the light emitting device package 105 according to another embodiment may be applied equally to those that are not described herein.

FIG. 11 illustrates an example of a light emitting device package 106 provided in the form of a chip scale package (CSP) in which a molding layer 171, in which wavelength conversion parts 130 and 140 and a light absorption part 150 are disposed, is coated in the form of a package on the light emitting device 120.

Referring to FIG. 11, the molding layer 171 having a certain thickness may be disposed on an outer surface of the light emitting device 120 excluding a bottom surface of the light emitting device 120.

An outer surface of the light emitting device 120 may be provided with a protective agent 161 applied thereon. For example, a powder-shaped protective agent 161 may be disposed on the outer surface of the light emitting device 120 to have a certain thickness. As another example, a resin layer in which the powder-shaped protective agent 161 is dispersed may be applied on the outer surface of the light emitting device 120.

For example, a molding layer 171 in which a first phosphor 130, a second phosphor 140, and a light absorption part 150 are dispersed may be coated and disposed on the light emitting device 120 coated with a protective agent 161.

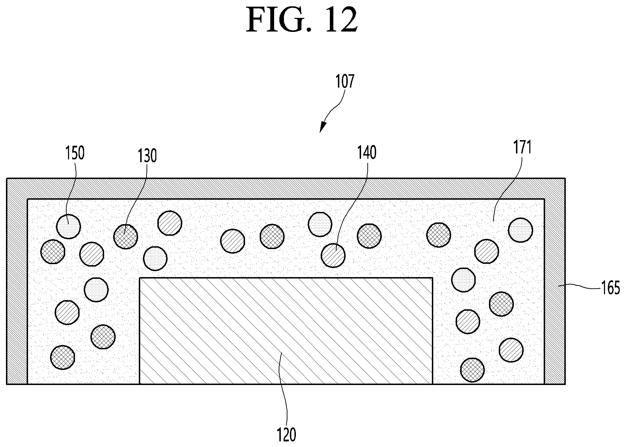

FIG. 12 illustrates an example of a light emitting device package 107 provided in the form of a chip scale package (CSP) in which a molding layer 171, in which wavelength conversion parts 130 and 140 and a light absorption part 150 are disposed, is coated in the form of a package on the light emitting device 120.

Referring to FIG. 12, the molding layer 171 having a certain thickness may be disposed on an outer surface of the light emitting device 120 excluding a bottom surface of the light emitting device 120.

For example, a protective agent 165 may be provided in the form of a layer on an outer surface of the molding layer 171. For example, the protective layer 165 containing an UV protection agent may be disposed on the outer surface of the molding layer 171.

For example, a powder-shaped protective agent 165 may be disposed to have a certain thickness. As another example, a resin layer in which the powder-shaped protective agent 165 is dispersed may be coated on the molding layer 171.

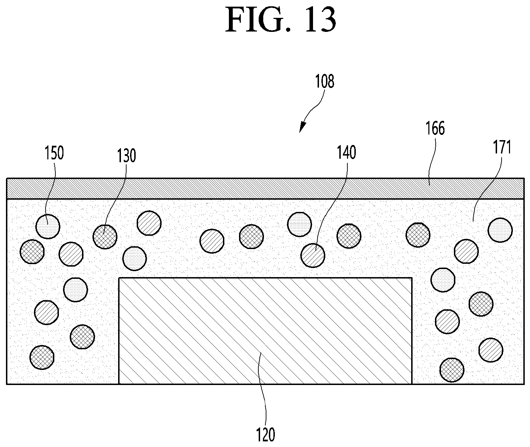

FIG. 13 illustrates an example of a light emitting device package 108 provided in the form of a chip scale package (CSP) in which a molding layer 171, in which wavelength conversion parts 130 and 140 and a light absorption part 150 are disposed, is coated in the form of a package on the light emitting device 120.

Referring to FIG. 13, the molding layer 171 having a certain thickness may be disposed on an outer surface of the light emitting device 120 excluding a bottom surface of the light emitting device 120.

For example, a protective agent 166 may be provided in the form of a layer on a top surface of the molding layer 171. For example, the protective layer 166 containing an UV protection agent may be disposed on the top surface of the molding layer 171.

For example, a powder-shaped protective agent 166 may be disposed to have a certain thickness. As another example, a resin layer in which the powder-shaped protective agent 166 is dispersed may be coated on the top surface of the molding layer 171.

FIG. 14 is a view illustrating a molecular structure as an example of the light absorption part according to embodiments of the present disclosure. FIG. 15 is a graph illustrating an effect of the light absorption part. FIGS. 16 and 17 are graphs illustrating characteristics of the protective agent.

As described above, the light absorption part 150 according to embodiments of the present disclosure may include organic powder. As an exemplary embodiment, the light absorption part 150 may include a Tetra Aza Porphyrin (TAP) material.

The light absorption material 150 may be damaged by ultraviolet rays. Thus, the protective agent 160 may protect carbon linkages of the organic powder from the ultraviolet rays.

Referring to FIG. 15, it is seen that a full width at half maximum of each of a green peak having a wavelength of about 500 nm and about 540 nm and a red peak having a wavelength of about 580 nm and about 620 nm is narrowed depending on an effect of the light absorption part 150, for example, the TAP material.

As described above, the peak of the spectrum of the first phosphor 130 and the peak of the spectrum of the second phosphor 140 may be narrowed due to an absorption spectrum peak by the light absorption part 150. Thus, the color purity of each of the light emitted from the first phosphor 130 and the light emitted from the second phosphor 140 may be improved.

When the material of the light absorption part 150 is damaged by the ultraviolet rays, and light absorbing performance is deteriorated, the effect of the material of the light absorption part 150 may be weakened, and a color purity may be reduced.

Therefore, it is possible to prevent the effect of the material of the light absorption part 150 from being weakened by using the protective agent 160 that protects the light absorption part 150.

The protective agent 160 may include a UV protection agent. The UV protection agent may contain an inorganic or organic material.

For example, the inorganic material may utilize at least one of zinc oxide (ZnO) or titanium oxide (TiO₂).

For example, the organic material may include at least one of 4-methylbenzylidene camphor, drometrizole, drometrizole trisiloxane, digalloyl trioleate, disodium phenyldibenzimidazole tetrasulfonate acid, diethylamino hydroxy benzoyl hexylbenzoate, diethylhexylbutamidotriazone, methylenebis-benzotriazolyltetramethylbutylphenol, menthyl anthranilate, benzophenone-3(oxybenzone), benzophenone-4, benzophenone-8(deoxybenzone), butylmethoxydibenzoylmethane, bisethylhexyloxyphenol methoxyphenyl triazine, cinoxate, ethylhexyl dimethyl paba, ethylhexyl methoxycinnamate, ethylhexyl salicylate, ethylhexyl triazone, octocrylene, isoamyl-p-methoxycinnamate, terephthalylidene dicamphor sulfonic acid and its salts, titanium dioxide, phenylbenzimidazole sulfonic acid, polysilicon-15(dimethicodiethylbenzalmalonate), or homosalate.

The UV protection agent may protect the light absorption part 150 by absorbing ultraviolet rays in a near ultraviolet range (about 300 nm to about 400 nm). A particle size of the UV protection agent may range of about 1 *µ*m to about 99 *µ*m. If the particle size of the UV protection agent is greater than about 100 *µ*m, it may not be easy to be implemented within the light emitting device package. For example, a size of a nozzle for dispersing or forming a layer to implement the protective agent 160 may not match.

Referring to FIG. 16, the protective agent 160 may have light resistance according to wavelengths. The light resistance refers to a property of preventing discoloration due to external light. According to the present disclosure, the protective agent 160 may have a characteristic of no discoloration depending on the light emitted from the light emitting device package 100.

Referring to FIG. 17, since heat generation of about 100°C or higher is typically generated in the light emitting device 120, the protective agent 160 may be required to have heat resistance. Referring to FIG. 17, it is seen that when the protective agent 160 having a weight ratio of about 100% is used, the heat resistance is achieved up to a temperature of about 400°C.

FIG. 18 is a schematic view illustrating a planar lighting device using the light emitting device package according to an embodiment of the present disclosure. FIG. 19 is a schematic view illustrating a planar lighting device using the light emitting device package according to another embodiment of the present disclosure.

Planar lighting devices 200 and 201 may largely include a plurality of light sources 100 and 105 (light emitting device packages) that emit white light, a light diffusion layer 220 disposed on the light emitting device packages 100 and 105, a light absorption layer 300 disposed on the light diffusion layer 200, and an optical sheet 400 disposed on the light absorption layer 300.

The light emitting device packages 100 and 105 may be, for example, arranged and provided on a circuit board 210. The plurality of light emitting device packages 100 and 105 may emit the white light. The plurality of light emitting device packages 100 and 105 may be disposed at regular intervals on the circuit board 210.

The light emitting device packages 100 and 105 may have configurations according to the embodiments described above. For example, the light emitting device package 100 described with reference to FIG. 1 or the light emitting device package 105 described with reference to FIG. 10 may be used. Duplicated descriptions thereof are omitted.

The light diffusion layer 220 may be disposed on the light emitting device packages 100 and 105. This light diffusion layer 220 may be configured to evenly mix the white light emitted from the plurality of light sources 100 and 105 provided as point light sources. That is, the light diffusion layer 220 may convert a point light source into a planar light source.

As described above, the light that is evenly diffused in the light diffusion layer 220 may be converted into a substantially uniform planar light source while passing through the optical sheet 230. The optical sheet 230 may include a plurality of functional layers.

FIG. 20 is a schematic view illustrating a display device according to an embodiment of the present disclosure.

Referring to FIG. 20, an example of a display device 10 including direct-type planar lighting devices 200 and 201 using the light emitting device package 100 according to an embodiment described above as a light source is illustrated. An example of the display device 10 including the planar lighting devices 200 and 201 may be a liquid crystal display device 10.

Referring to FIG. 20, in the liquid crystal display device 10, the planar lighting devices 200 and 201 may be disposed on a lower cover 310. The planar lighting devices 200 and 201 may include at least one of the light emitting device packages 100 to 108 according to embodiments of the present disclosure. FIG. 20 illustrates an example of the planar lighting devices 200 and 201 that use the light emitting device package 100 according to an embodiment as the light source.

Each of the planar lighting devices 200 and 201 may include an additional optical sheet 240. A reflective sheet 250 may be disposed between each of the planar lighting devices 200 and 201 and the lower cover 310.

A liquid crystal display panel 300 may be disposed on the planar lighting devices 200 and 201. In addition, the liquid crystal display panel 300 may be supported by a mold frame 330. An upper cover 320 may be disposed on the mold frame 330.

FIG. 21 is a schematic view illustrating a display device according to another embodiment of the present disclosure.

Referring to FIG. 21, an example of a display device 10 including side-type planar lighting devices 200 and 201 using the light emitting device package 100 according to an embodiment described above as a light source is illustrated. An example of the display device 10 including the planar lighting devices 200 and 201 may be a liquid crystal display device 10.

The side-type planar lighting devices 200 and 201 may diffuse light using a light guide plate 260.

Referring to FIG. 21, in the liquid crystal display device 11, the planar lighting devices 200 and 201 may be disposed on a lower cover 310. The planar lighting devices 200 and 201 may include at least one of the light emitting device packages 100 to 108 according to embodiments of the present disclosure. FIG. 21 illustrates an example of the planar lighting devices 200 and 201 that use the light emitting device package 100 according to an embodiment as the light source.

Each of the planar lighting devices 200 and 201 may include an additional optical sheet 240. A reflective sheet 250 may be disposed between each of the planar lighting devices 200 and 201 and the lower cover 310.

A liquid crystal display panel 300 may be disposed on the planar lighting devices 200 and 201. In addition, the liquid crystal display panel 300 may be supported by a mold frame 330. An upper cover 320 may be disposed on the mold frame 330.

A heat bar 270 may be disposed at one side of the mold frame 330, and the light emitting device package 100 may be disposed on the heat bar 270. In the light emitting device package 100, light may be irradiated toward the light guide plate 260.

According to the embodiment of the present disclosure, the color purity of the white light emitted from the light emitting device package may be improved. When the light emitting device package is used in the planar lighting device, the color reproducibility of the planar lighting device may be further improved.

According to the embodiments of the present disclosure, the light absorption part may be prevented from being damaged by the ultraviolet rays or at least partially prevented from being damaged by the ultraviolet rays due to the role of the protective agent.

Therefore, the light absorption part may maintain the light absorption performance for the long period of time, and thus, the performance of improving the color purity described above may be maintained.

Furthermore, according to another embodiment of the present disclosure, there may be additional technical effects, which are not mentioned herein. A person skilled in the art may understand the full scope of the specification and drawings.

Features, structures, and effects described in the above embodiments are incorporated into at least one embodiment, but are not limited to only one embodiment. Moreover, features, structures, and effects exemplified in one embodiment can easily be combined and modified for another embodiment by those skilled in the art. Therefore, these combinations and modifications should be construed as falling within the scope of the present invention.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A light emitting device package comprising:
a light emitting device (120) configured to emit light having a first color;
a wavelength conversion part (130, 140) having a first main emission wavelength and a second main emission wavelength and disposed around the light emitting device (120) to convert a wavelength of at least a portion of the light having the first color emitted from the light emitting device (120) to light having a second color;
a light absorption part (150) having an absorption center wavelength between the wavelength corresponding to the first color and the wavelength corresponding to the second color of the wavelength conversion part (130, 140); and
a protective agent (160) configured to protect the light absorption part from at least a portion of ambient light.

2. The light emitting device according to claim 1, wherein the protective agent (160) includes a UV protection agent.

3. The light emitting device according to claim 2, wherein the UV protection agent is configured to block at least a portion of light having a wavelength band of 300 nm to 400 nm.

4. The light emitting device according to claim 1, wherein the light absorption part (150) and the protective agent (160) are distributed in a molding layer (170) disposed on the light emitting device (120).

5. The light emitting device according to claim 4, wherein a density of the light absorption part (150) within the molding layer (170) is greater than a density of the protective agent (160).

6. The light emitting device according to claim 4 or claim 5, wherein the protective agent (160) is coated on the light emitting device (120).

7. The light emitting device according to any one of claims 4 to 6, wherein the molding layer (170) is disposed within a reflective cup provided in a package body (110) provided with the light emitting device (120).

8. The light emitting device according to claim 1, wherein the light absorption part (150) is distributed in a molding layer (170) disposed on the light emitting device (120), and
wherein the protective agent (160) is provided in the form of a layer on an outer surface of the molding layer (170).

9. The light emitting device according to any one of the proceeding claims, wherein the light absorption part (150) has an absorption center wavelength of 585 nm to 605 nm.

10. The light emitting device according to any one of the proceeding claims, wherein the light absorption part (150) includes organic power.

11. The light emitting device according to claim 10, wherein the protective agent (160) is configured to protect carbon link of the organic powder from ultraviolet rays.

12. A planar lighting device comprising:
the light emitting device package (100) according to any one of claims 1 to 11;
a light diffusion layer (220) disposed on the light emitting device package (100); and
an optical sheet (230) disposed on the light diffusion layer (220).

13. The planar lighting device according to claim 12, wherein the protective agent is configured to block at least a portion of light having a wavelength band of 300 nm to 400 nm.

14. The planar lighting device according to claim 12 or claim 13, wherein the light absorption part (150) includes organic powder, and
wherein the protective agent is configured to protect carbon link of the organic powder from ultraviolet rays.

15. A display device comprising:
a planar lighting device (200, 201) comprising the light emitting device package (100) according to any one of claims 1 to 11; and
a liquid crystal display panel (300) disposed on the planar lighting device (200, 201),
a light diffusion layer (220) disposed on the light emitting device package (200, 201); and
an optical sheet (230) disposed on the light diffusion layer (220).
